# EUROPEAN PATENT APPLICATION

(11) **EP 4 542 855 A1**
(43) Date of publication of application: **23.04.2025**
(21) Application number: 24205178.7
(22) Date of filing: 08.10.2024
(51) Int. Cl.: H03F 1/02, H03F 3/19, H03F 3/21, H03F 3/24, H03F 3/68, H03F 3/72

(54) **MANAGEMENT OF POWER AMPLIFIERS**

(30) Priority: 18.10.2023 GB 202315913
(71) Applicant: Nokia Technologies Oy, 02610 Espoo (FI)
(72) Inventor: JALILI, Feridoon, 9260 Gistrup (DK); NIELSEN, Kim, 9280 Storvorde (DK); SVENDSEN, Simon, 9000 Aalborg (DK); VEJLGAARD, Benny, 9260 Gistrup (DK); HARREBEK, Johannes, 9000 Aalborg (DK)
(74) Representative: Nokia EPO representatives

(57) **Abstract**

An apparatus comprising
a plurality of power amplifiers, wherein at least some of the plurality of power amplifiers have different maximum output power capabilities;
a multiplicity of antenna ports;
control means configured to select a set of one or more power amplifiers from the plurality of power amplifiers for simultaneous transmission via respective antenna ports.

## Description

### TECHNOLOGICAL FIELD

Examples of the disclosure relate to management of power amplifiers.

### BACKGROUND

Power amplifiers are used in radio telecommunications to transmit radio signals.

A power amplifier is coupled to an antenna element via an antenna port.

The efficiency of a power amplifier can decrease significantly when it is operated with backoff from its maximum output power capability.

### BRIEF SUMMARY

According to various, but not necessarily all, examples there is provided an apparatus comprising:
a plurality of power amplifiers, wherein at least some of the plurality of power amplifiers have different maximum output power capabilities;
a multiplicity of antenna ports;
control means configured to select a set of one or more power amplifiers from the plurality of power amplifiers for simultaneous transmission via respective antenna ports.

In some but not necessarily all examples, the control means is configured to control a combined total transmit power of the set of one or more power amplifiers to be less than or equal to a combined total transmit power target.

In some but not necessarily all examples, the control means is configured to select the set of power amplifiers such that the power amplifiers in the set have different maximum output power capabilities.

In some but not necessarily all examples, the control means is configured to select the set of power amplifiers such that the power amplifiers in the set have lowest maximum output power capabilities sufficient for a combined total transmit power of the set of one or more power amplifiers to meet a combined total transmit power target.

In some but not necessarily all examples, the control means is configured to evenly distribute a combined total transmit power of the set of one or more power amplifiers across the set of one or more power amplifiers, wherein the power amplifiers in the set are controlled to have the same power output simultaneously.

In some but not necessarily all examples, the control means is configured to select a set of one or more power amplifiers from the plurality of power amplifiers for simultaneous transmission via respective antenna ports and distribute a combined total transmit power of the set of one or more power amplifiers across the set of one or more power amplifiers, to achieve a distribution of a maximum total transmit power target across a number of power amplifiers required that reduces or minimizes backoff from maximum output power capabilities of the power amplifiers.

In some but not necessarily all examples, the combined total transmit power of the set of one or more power amplifiers is determined at the respective antenna ports and includes an estimate of path loss between each power amplifier in the set of one or more power amplifiers and its respective antenna port.

In some but not necessarily all examples, the control means is configured to replace a power amplifier in the set of one or more power amplifiers in response to a requirement to increase the combined total transmit power of the set, only if the output power of the power amplifier, for replacement, has reached its maximum output power capability.

In some but not necessarily all examples, the control means is configured to select for addition to the set of one or more power amplifiers an additional power amplifier from the remaining power amplifiers of the plurality of power amplifiers that are not presently in the set, wherein the selected additional power amplifier is the power amplifier of the remaining power amplifiers that has the lowest maximum output power capability amongst the remaining power amplifiers.

In some but not necessarily all examples, the control means is configured to select an antenna port for each of the power amplifiers in the set of one or more power amplifiers based on an estimate of power loss in transmission channels associated with the antenna ports and/or an estimate of power loss in the paths between the path loss the power amplifiers in the set of one or more power amplifiers and the respective selectable antenna ports.

In some but not necessarily all examples, the control means is configured to select an antenna port for a power amplifier of a primary carrier that has the best estimate of power loss in a transmission channel associated with the antenna port.

In some but not necessarily all examples, the control means is configured to control a switching arrangement between the plurality of power amplifiers and the multiplicity of antenna ports, wherein the switching arrangement is configured to connect each of the plurality of power amplifiers to at least one antenna port and at least a first one of the plurality of power amplifiers to any one of multiple different of the multiplicity of antenna ports, wherein the first one of the plurality of power amplifiers has the greatest maximum output power capability amongst the plurality of power amplifiers.

In some but not necessarily all examples, the control means is configured to switch a power amplifier having a greatest maximum output power capability amongst the plurality of power amplifiers to any one of the a first number of the multiplicity antenna ports and a power amplifier that has the lowest maximum output power capability amongst the plurality of power amplifiers to any one of the first number of the multiplicity of antenna ports, wherein the first number is the maximum number of antenna ports to which any of the plurality of power amplifiers is switchable and the second number is a minimum number of antenna ports to which any of the plurality of power amplifiers is switchable.

In some but not necessarily all examples, the apparatus comprises a multiplicity of antennas wherein each of the multiplicity of antennas is coupled to one of the multiplicity of antenna ports for at least transmission.

In some but not necessarily all examples, the apparatus is comprised in a user equipment configured for communication with a cellular telecommunications network, wherein one or more of the plurality of power amplifiers are configurable for simultaneous uplink transmission to the cellular telecommunications network.

In some but not necessarily all examples, one of the plurality of power amplifiers meets, by itself, a maximum output power requirement controllable via downlink control signaling by the cellular telecommunications network.

According to various, but not necessarily all, examples there is provided a method comprising: select a set of one or more power amplifiers from a plurality of power amplifiers for simultaneous transmission via respective antenna ports, wherein at least some of the plurality of power amplifiers have different maximum output power capabilities.

According to various, but not necessarily all, examples there is provided a computer program comprising instructions that when executed by one or more processors causes: selection of a set of one or more power amplifiers, from a plurality of power amplifiers, for simultaneous transmission via respective antenna ports, wherein at least some of the plurality of power amplifiers have different maximum output power capabilities.

According to various, but not necessarily all, examples there is provided examples as claimed in the appended claims.

While the above examples of the disclosure and optional features are described separately, it is to be understood that their provision in all possible combinations and permutations is contained within the disclosure. It is to be understood that various examples of the disclosure can comprise any or all of the features described in respect of other examples of the disclosure, and vice versa. Also, it is to be appreciated that any one or more or all of the features, in any combination, may be implemented by/comprised in/performable by an apparatus, a method, and/or computer program instructions as desired, and as appropriate.

### BRIEF DESCRIPTION

Some examples will now be described with reference to the accompanying drawings in which:
FIG. 1 shows an example of the subject matter described herein;
FIG. 2 shows another example of the subject matter described herein;
FIG. 3A shows another example of the subject matter described herein;
FIG. 3B shows another example of the subject matter described herein;
FIG. 4 shows another example of the subject matter described herein;
FIG. 5 shows another example of the subject matter described herein;
FIG. 6A to 6F show examples of the subject matter described herein;
FIG. 7A & 7B shows other examples of the subject matter described herein;
FIG. 8 shows another example of the subject matter described herein;
FIG. 9 shows another example of the subject matter described herein;
FIG. 10 shows another example of the subject matter described herein;
FIG. 11 shows another example of the subject matter described herein;
FIG. 12 shows another example of the subject matter described herein;
FIG. 13 shows another example of the subject matter described herein.

The figures are not necessarily to scale. Certain features and views of the figures can be shown schematically or exaggerated in scale in the interest of clarity and conciseness. For example, the dimensions of some elements in the figures can be exaggerated relative to other elements to aid explication. Similar reference numerals are used in the figures to designate similar features. For clarity, all reference numerals are not necessarily displayed in all figures.

In the following description a class (or set) can be referenced using a reference number without a subscript index (for example 20) and a specific instance of the class (member of the set) can be referenced using the reference number with a numerical type subscript index (for example 20_1) and a non-specific instance of the class (member of the set) can be referenced using the reference number with a variable type subscript index (for example 20_i).

### DETAILED DESCRIPTION

The following description describes examples of an apparatus 10 comprising: a plurality of power amplifiers 20_i, wherein at least some of the plurality of power amplifiers 20_i have different maximum output power capabilities 22_i; a multiplicity of antenna ports 30_j; and control means 40 configured to select a set 60 of one or more power amplifiers 20_i from the plurality of power amplifiers 20_i for simultaneous transmission via respective one or more antenna ports 30_j.

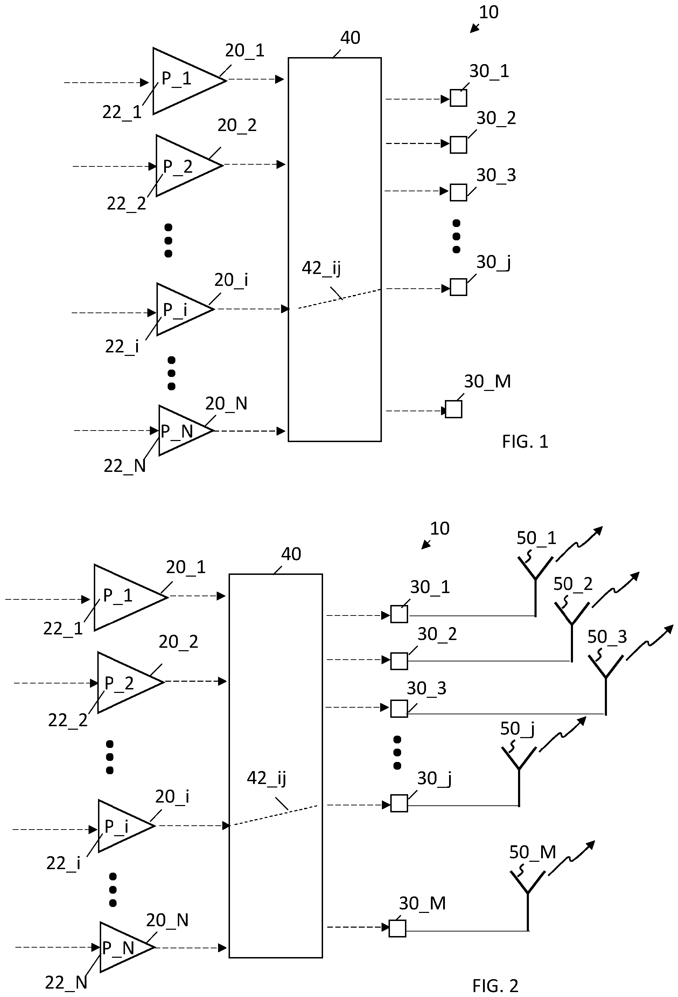

FIG 1 illustrates an example of an apparatus 10 comprising: a plurality of power amplifiers 20_i, a multiplicity of antenna port 30_j; and a controller 40 configured to select a set 60 (not illustrated in FIG 1) of one or more power amplifiers 20_i from the plurality of power amplifiers 20_i for simultaneous transmission via respective antenna port 30_j. At least some of the plurality of power amplifiers 20_i have different maximum output power capabilities 22_i.

It is possible to buy different specifications of PA off-the-shelf from a component manufacturer. It is therefore possible to buy a first power amplifier as a component that has a maximum output power of 24dBm, for example, for a given set of biasing/operating conditions, and buy a second power amplifier as a component that has a maximum output power of 19dBm, for example, for a given set of biasing/operating conditions, The second power amplifier cannot provide a 24dBm output power level, but the first PA can provide a 19dBm output power level by being controlled ("biased" or "backed off") to operate at a lower output power level (albeit at a change in efficiency).

In this example there are M antenna ports 30_j and N power amplifiers 20_i. In some but not necessarily all examples M and N are different. In some but not necessarily all examples M and N are equal. Each power amplifier 20_i has an associated maximum output power capability 22_i. This is a maximum power level P_i at which the power amplifier 20_i can be operated by the apparatus 10.

In the example illustrated the controller 40 couples power amplifier 20_i to antenna port 30_j for transmission via the antenna port 30_j. The coupling is via a path 42_ij.

In this example the controller 40 is configured to couple one power amplifier 20_i to one antenna port 30_j and one antenna port 30_j to one power amplifier 20_i via one path 42_ij.

FIG 2 illustrates that in at least some examples the apparatus 10 as described can comprise or can be augmented with antenna elements 50. Each antenna port 30_j is coupled to a respective antenna element 50_j and each antenna element 50_j is coupled to its respective antenna port 30_j.

In some but not necessarily all examples the apparatus 10 is a module for a user equipment. Such a module can comprise antenna elements 50. Alternatively, the antenna elements 50 can be connected to the module.

In some but not necessarily all examples the apparatus 10 is a user equipment or is comprised in a user equipment with the antenna ports 30_i being connected to respective antenna elements 50_i.

In some but not necessarily all examples, the power amplifiers 20 and support circuitry are disposed on a printed circuit board (PCB) of user equipment. The antenna elements 50 can, for example, be disposed elsewhere in the user equipment (for example attached to an inside surface of a cover of the user equipment) and connected to the antenna ports 30 which reside on the PCB.

The set 60 of power-amplifiers 20_x can, for example, have M members each of which is selectively coupled to a unique one of M antenna ports 30_y (or antenna elements 50). Each of the antenna ports 30_y is connected permanently to an antenna element 50_y.

In at least some examples, the user equipment is configured for communication with a cellular telecommunications network. The set 60 of power amplifiers 20_i are configurable for simultaneous uplink transmission (UL Tx) to the cellular telecommunications network.

Multiple simultaneous UL Tx can for example be used to increase robustness of communication by providing multiple alternative UL Tx channels.

Multiple simultaneous ULTx can for example be used to increase bandwidth of communication by providing multiple parallel UL Tx channels.

Multiple simultaneous UL Tx can for example be used for carrier aggregation (CA) and/or dual connectivity (DC) and/or UL Tx diversity.

Multiple simultaneous UL Tx can for example be used for multiple-input multiple output (MIMO) operation. This uses the same frequency band for all UL Tx.

In some but not necessarily all examples, the UL Tx occurs in a frequency range between 7 and 24 GHz. The antenna elements 50 can be optimized for use within the same operational bandwidth within that frequency range.

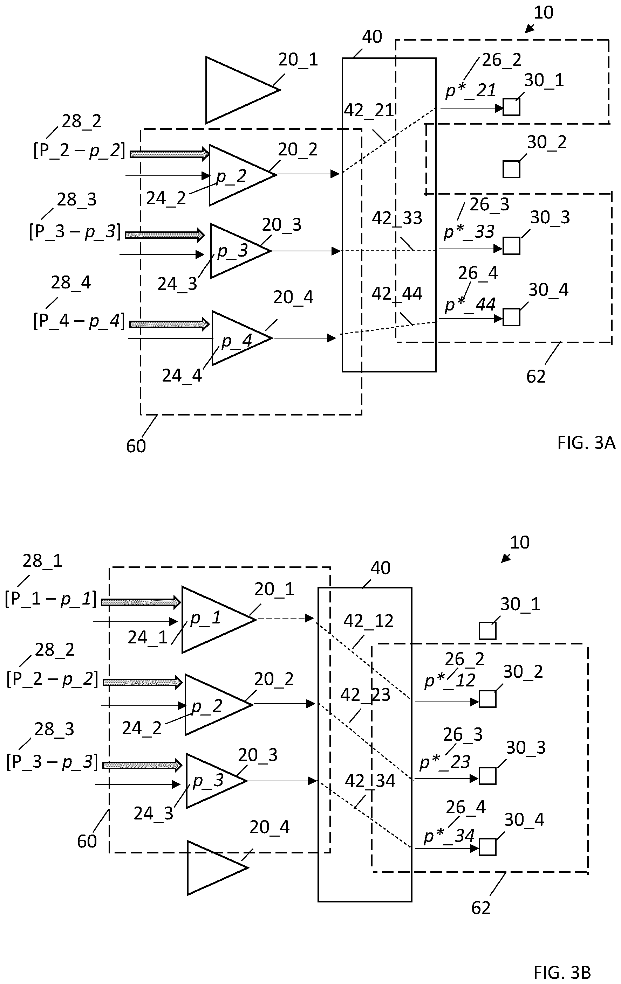

FIGs 3A & 3B illustrate operation of the apparatus 10 as described. The controller 40 selects a set 60 of one or more power amplifiers 20_i from the plurality of power amplifiers 20_i for simultaneous transmission via respective antenna ports 30J.

Each power amplifier 20_i has an associated maximum output power capability 22_i. This is a maximum power level P_i at which the power amplifier 20_i can be operated by the apparatus 10.

Each power amplifier 20_i in the set 60 is operated with a power p_i, the operational power 24_i. The difference between the maximum power level P_i and the operational power level p_i for a power amplifier 20_i is the backoff 28_i.

In general, the controller 40 couples the power amplifier 20_i to the antenna port 30_j via path 42_ij. That power amplifier 20_i has an associated maximum output power capability 22_i and is operated with a backoff 28_i providing an operational power 24_2. The path 42_ij can have an associated path loss L_ij. The operational output power 26_j at the antenna port 30_j has a level p*_ij equal to p_ij - L_ij.

In the example illustrated in FIG 3A, the controller 40 couples the power amplifier 20_2 to the antenna port 30_1 via path 42_21. The power amplifier 20_2 is operated with a backoff 28_2 from its maximum power level P_2 and has an operational power 24_2 (p_2). This produces operational output power 26_2 (p*21) at the antenna port 30_1.

The controller 40 couples the power amplifier 20_3 to the antenna port 30_3 via path 42_33. The power amplifier 20_3 is operated with a backoff 28_3 from its maximum power level P_3 and has an operational power 24_3 (p_3). This produces an operational output power 26_3 (p*_33) at the antenna port 30_3.

The controller 40 couples the power amplifier 20_4 to the antenna port 30_4 via path 42_44. The power amplifier 20_4 is operated with a backoff 28_4 from its maximum power level P_4 and has an operational power 24_4 (p_4). This produces an operational output power 26_4 (p*_44) at the antenna port 30_4.

In this example, the power amplifier 20_1 is not used. In this example, the antenna port 30_2 is not used. The set 60 consists of the power amplifiers 20_2, 20_3, 20_4. The associated set 62 of antenna ports 30 consists of the antenna ports 30_1, 30_3, 30_4.

In the example illustrated in FIG 3B, the controller 40 couples the power amplifier 20_1 to the antenna port 30_2 via path 42_12. The power amplifier 20_1 is operated with a backoff 28_1 from the maximum power level P_1 and has an operational power 24_1 (p_1). This produces operational output power 26_2 (p*_12) at the antenna port 30_2.

The controller 40 couples the power amplifier 20_2 to the antenna port 30_3 via path 42_23. The power amplifier 20_2 is operated with a backoff 28_2 from the maximum power level P_2 and has an operational power 24_2 (p_2). This produces an operational output power 26_3 (p*_23) at the antenna port 30_3.

The controller 40 couples the power amplifier 20_3 to the antenna port 30_4 via path 42_34. The power amplifier 20_3 is operated with a backoff 28_3 from the maximum power level P_3 and has an operational power 24_3 (p_3). This produces an operational output power 26_4 (p*_34) at the antenna port 30_4.

In this example, the power amplifier 20_4 is not used. In this example, the antenna port 30_1 is not used. The set 60 consists of the power amplifiers 20_1, 20_2, 20_3. The associated set 62 of antenna ports 30 consists of the antenna ports 30_2, 30_3, 30_4.

Referring to FIGs 1, 2, 3A and 3B, it can be desirable to use the controller 40 to avoid the use of a certain antenna port 30_1 because of path loss in the transmission channel associated with that antenna port 30_1. This can, for example, arise from interference local to a specific antenna 50.

It can be desirable to use the controller 40 to avoid the use of certain power amplifiers 20 to reduce power consumption and/or improve operational efficiency. This can be achieved by controlling which power amplifiers 20_i are coupled to which antenna ports 30_j by the controller 40.

It can be desirable to use the controller 40 to control the use of certain power amplifiers 20 to reduce power consumption and/or improve operational efficiency. This can be achieved by controlling the back-offs 28_i of the selected power amplifiers. As the power amplifiers 20_i can have different maximum output power capabilities the back-off can also be dependent upon the selection of the set 60 of power amplifiers 20_i by controller 40.

The controller 40 (the controller) is configured to control a combined total transmit power of the set 60 of one or more power amplifiers 20_i to be less than or equal to a combined total transmit power target (T).

The combined total transmit power target (T) can for example be a target based on a maximum transmit power limit Pmax specifiable by a network. The network can for example use a defined number of different user equipment Power Classes. The UE power class defines the maximum UL transmit power by the UE 10 over the channel bandwidth. The power class can change with UL Tx frequency. Currently Power Class 2 has a maximum output power of 26 dBm (+2/-3 dB and power class 3 has a maximum output power of 23 dBm (+2/ -2 to -3 dB).

The power class used by a UE 10 can be based on network commands. In some examples, the power class used can be based on percentage of uplink symbols relative to a UE or a specific threshold or a fixed 50% threshold.

In the following example, the power amplifiers 20_i in the selected set 60 are controlled to have the same target. The target can, in some examples, be set for the combination of operational power 24_i (p_i). That is p_i is the same for all power amplifiers in the set 60. The target can, in some examples, be set for a combination of operational output power 26_3 (p*) at the antenna port 30_3. That is p_i* is the same for all power amplifiers 20_i in the set 60. The former is the same as the latter if losses, for example path losses L_ij, are constant or ignored.

Therefore without loss of generality, it can be assumed that the operational output power 26_3 (level p*_ij ) is the same for all power amplifiers 20_i in the set.

If there are m antenna ports and the total transmit power target is T, then the target power for each power amplifier 24_i in the set is t=T/m.

The power amplifier 20_i is connected via path 42_ij to the antenna port 30_j. The path 42_ij has a path loss L_ij. The operational power 24_i is p_i and the operational output power 26_j is p*_ij where p_i = p*_ij + L_ij = t + L_ij.

The controller 40 selects m pairs (i,j) (where there are m different i and m different j).

The selection can be based on different optimization algorithms or combinations of optimization algorithms. The selection can be based on different constraints.

For example, one constraint is that for the power amplifier 20_i to be in the set 60, then the operational power p_i for the power amplifier 20_i must be less than or equal to the maximum output power capability (P_i) of that power amplifier 20_i. The power amplifier 20_i must have sufficient output power capability.

For example, in some examples the backoff 28 is minimized, for example minimize the difference between the maximum output power capability (P_i) of the power amplifier 20_i and the operational power p_i of the same power amplifier 20_i.

The minimization can for example minimize the sum of backoffs 28 across the set 60 (minimize the mean) and/or the minimization can for example minimize the median across the set 60. This can encourage the use of the power amplifiers 20 that have the lowest workable maximum output power capability P_i.

The controller 40 can for example select power amplifiers 20_i for the set 60 to reduce or minimize a summation of the differences between an operational power (p_i) of a power amplifier 20_i, in the set 60, and a maximum output power capability 22_i of the respective power amplifier 20_i.

The controller 40 can for example select power amplifiers 20_i for the set 60 to reduce or minimize a maximum difference between an operational power of a power amplifier 20_i, in the set 60, and a maximum output power capability 22_i of the respective power amplifier 20_i.

It may be desirable to constrain what antennas are used.

For example, it may be desirable to constrain a particular power amplifier 20 to use only a specific antenna 50 permanently or on a variable basis, for example in dependence upon uplink transmission channel loss for the different antenna elements.

For example, it may be desirable to constrain the particular power amplifiers 20 that are available to use only those with a maximum output power capability P_i above a minimum value.

For example, it may be desirable to constrain the particular power amplifiers that are available to use only those with a maximum output power capability P_i below a maximum value.

For example, it may be desirable to constrain the particular paths available between power amplifiers and antenna ports based on the power loss L_ij for the paths 42_ij.

If we assume that the power amplifier 20_1 has the greatest output power capability P_1. In some examples it can be desirable to be able to meet the combined total transmit power target (T) using only the power amplifier 20_1. In this example, P_1=T.

It can also be desirable to be able to meet the combined total transmit power target (T) using both the power amplifier 20_1 and the power amplifier 20_2. Thus, the operation of the power amplifier 20_1 at output power P_2 and the operation of the power amplifier 20_2 at its maximum capability P_2 provide an output power 2P_2 equal to the transmit power target (T). In dBm, 10log(T)= 10log (P_2 + P_2)= 10log P_2 + 10log2 & 10log P_2 = 10log(T) -10 log 2.

It can also be desirable to be able to meet the combined total transmit power target (T) using the power amplifier 20_1, the power amplifier 20_2 and the power amplifier 20_3. Thus the operation of the power amplifier 20_1 at output power P_3, the operation of the power amplifier 20_2 at output power P_3 and the operation of the power amplifier 20_3 at maximum capability P_3 provide an output power 3P_3 equal to the transmit power target (T). In dBm 10log(T)= 10log (3* P_3)= 10log P_2 + 10log3 & 10log P_3 = 10log(T) -10 log 3

It will therefore be appreciated that, in at least some examples, the controller 40 is configured to select the set 60 of power amplifiers 20_i such that the power amplifiers 20_i in the set 60 have different maximum output power capabilities 22_i. The control means 40 can be configured to select the set 60 of power amplifiers 20_i such that the power amplifiers 20_i in the set 60 have lowest maximum output power capabilities 22_i sufficient for a combined total transmit power of the set 60 of one or more power amplifiers 20_i to meet a combined total transmit power target.

In at least some examples, the power amplifiers 20 have a peak in PAE (power added efficiency) at the maximum output power defined by their maximum output power capability P_i. An increase in back-off 28_i for a power amplifier 20_i reduces its power added efficiency. The selection of the set 60 of power amplifiers 20_i can be based on a reduction or optimization (for example minimization) of a cost function based on a difference between an operational power (p_i) of a power amplifier 20_i at the power amplifier 20_i and a maximum output power capability 22_i (P_i) of the respective power amplifier 20_i, wherein the selection of the set 60 of power amplifiers 20_i optimizes the cost function. The cost function can also take into account path losses.

In at least some examples, the controller 40 is configured to evenly distribute a combined total transmit power of the set 60 of one or more power amplifiers 20_i across the set 60 of one or more power amplifiers 20_i, wherein the power amplifiers 20_i in the set 60 are controlled to have the same power output simultaneously.

In at least some examples, the controller 40 is configured to select a set 60 of one or more power amplifiers 20_i from the plurality of power amplifiers 20_i for simultaneous transmission via respective antenna ports 30J and distribute a combined total transmit power of the set 60 of one or more power amplifiers 20_i across the set 60 of one or more power amplifiers 20_i, to achieve a distribution of a maximum total transmit power target (T) across a number (m) of power amplifiers 20_i required that reduces or minimizes backoff 28 from maximum output power capabilities 22_i of the power amplifiers 20_i.

The combined total transmit power of the set 60 of one or more power amplifiers 20_i is determined at the respective antenna port 30_j and includes an estimate of path loss L_ij between each power amplifier 20_i in the set 60 of one or more power amplifiers 20_i and its respective antenna port 30_j. The estimate of path loss L_ij can be the same for all paths or can be a calibrated value, in which the calibration value contains the information of the loss L_ij.

The apparatus 10 can be calibrated for each power amplifier 20_i at the antenna port 30_j with insertion loss, while each power amplifier 20_i is additionally measured for delta power on other configurable antenna ports 30_j the power amplifier output can be routed to.

The calibration of the power loss L_ij based on the path 42_ij can be performed on a per antenna port 30_j basis.

The calibration of the power loss L_ij based on the path 42_ij can be performed on a per power amplifier 20_i basis.

The calibration of the power loss L_ij based on the path 42_ij can be performed on a per frequency band basis, or on a per frequency step basis for higher error correction.

In at least some examples, the controller 40 is configured to assign the power amplifiers 20_i to respective antenna ports 30_j such that the power amplifier 20_i with the relative greatest maximum output power capability 22_i in the set 60 is assigned to an antenna port 30_j with the relative largest estimated path loss for the set 60. This reduces back-off 28_i as the compensation of the path loss increases operational power level p_i, decreasing backoff 28_i.

In some examples, it is possible to extend the concept of power loss to the radio transmission channel. For example, the radio transmission channel power loss associated with the antenna 50J could be added to the power loss L_ij associated with each path 42_ij.

In some examples, the controller 40 is configured to select a respective antenna port 30_j for each of the power amplifiers 20_i in the set 60 of one or more power amplifiers 20_i based on an estimate of power loss in transmission channels associated with the antenna port 30J and/or an estimate of power loss in the paths between the power amplifiers 20_i in the set 60 of one or more power amplifiers 20_i and the respective selectable antenna port 30_j.

In some examples, the controller 40 is configured to select an antenna port 30_j for a power amplifier 20_i of a primary component carrier that has the best estimate of power loss in transmission channels associated with the antenna port 30_j.

The primary component carrier (PCC) is granted the best antenna 50_i (lowest transmission path loss) and the second component carrier (SCC) must be allocated to a combination of power amplifier 20 and antenna port 30 that excludes the power amplifier 20 and the antenna port 30 previously assigned to the PCC based on other optimization such as minimizing back-off.

Back-off can be minimized by reducing path loss. In some examples, this is achieved by routing the power-amplifier 20_i to its nearest antenna port 30_i.

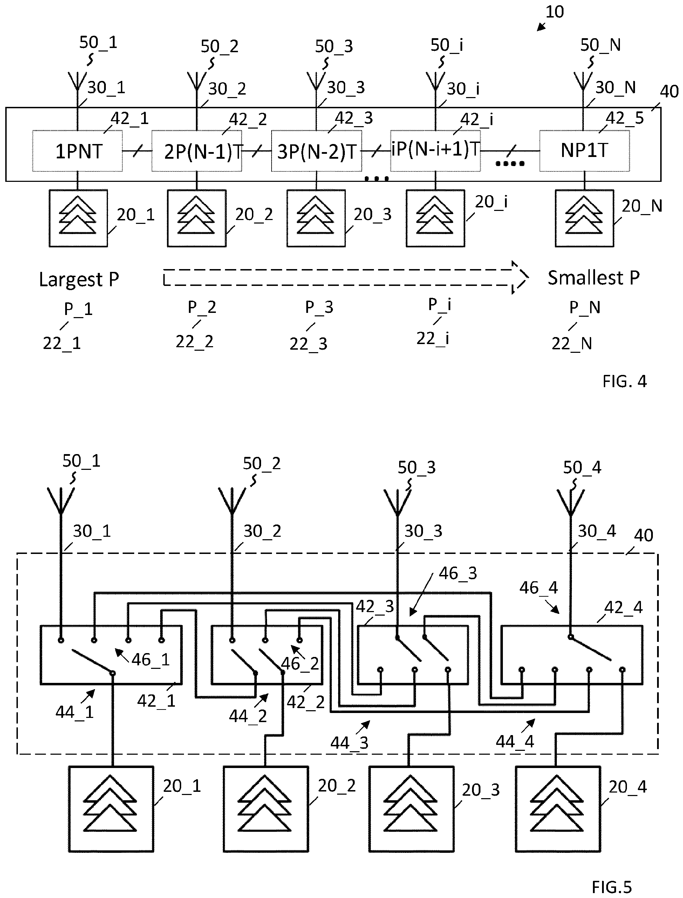

FIG 4 illustrates an example wherein the controller 40 is configured as a switching arrangement comprising switches 42_i.

The apparatus 10 comprises: a plurality of power amplifiers 20_i, a multiplicity of antenna ports 30_j connected to respective antenna elements 50_j; and a controller 40 configured to select a set 60 (not illustrated in FIG 4) of one or more power amplifiers 20_i from the plurality of power amplifiers 20_i for simultaneous transmission via respective antenna ports 30_j. At least some of the plurality of power amplifiers 20_i have different maximum output power capabilities 22_i.

In this example there are N antenna ports 30_j and N power amplifiers 20_i. Each power amplifier 20_i has an associated maximum output power capability 22_i. This is a maximum power level P_i at which the power amplifier 20_i can be operated by the apparatus 10.

In this example the controller 40 is configured to map one power amplifier 20_i to one antenna port 30_j and one antenna port 30_j to one power amplifier 20_i via one path 42_ij (not illustrated). There is a set of mappings between the power amplifiers 20_i in the set 60 and respective antenna ports 30_j. In this example, the mapping is controlled by the state of the switches 42J.

In this example, the power amplifier 20_i is connected to a iP(N-i+1)T switch 42_i. The iP(N-i+1)T switch 42_i is a switch that has i poles and (N-i+1) throws. One of the throws is connected to the antenna port 30_i. Each of the other N-i throws is connected to one of the antenna ports 30_k, where k>i i.e. k= i+1, i+2....N. One of the poles is connected to the power amplifier 20_i. Each of the other i-1 poles is connected to one of the throws from respective switches 20_p, where p<i i.e. p= i-1, i-2....1.

Thus, the first power amplifier 20_1 (i=1) is connected to a 1PNT switch 42_1. The 1PNT switch 42_1 is a switch that has 1 pole and N throws. One of the throws is connected to the antenna port 30_1. Each of the other N-1 throws is connected to one of the antenna ports 30_k, where k>1 i.e. k= 2, 3....N. One of the poles (the only pole) is connected to the power amplifier 20_1.

Thus, the last power amplifier 20_ N (i=N) is connected to a NP1T switch 42_N. The NP1T switch 42_N is a switch that has N poles and 1 throw. One of the throws (the only throw) is connected to the antenna port 30_N. One of the poles is connected to the power amplifier 20_i. Each of the other N-1 poles is connected to one of the throws from respective switches 20_p, where p<N i.e. p= N-1, N-2....1.

In this example, the first power amplifier 22_1 is the most powerful power amplifier and has the largest output power capability P_1. The last power amplifier 22_N is the least powerful power amplifier and has the smallest output power capability P_N. The FIG 4 illustrates a general trend where the output power capability P_i decreases as i increases.

In some examples, the output power capability P_i of the power amplifier 20_i is Pm -10log(i) dBm.

FIG 5 illustrates an example of FIG 4 where N=4.

This example illustrates the poles 44_i and throws 46_i of respective switches 42_i and their connections.

In this example, the power amplifier 20_i is connected to an iP(5-i)T switch 42_i. The iP(5-i)T switch 42_i is a switch that has i poles 44_i and (5-i) throws 46_i. One of the throws is connected to the antenna port 30_i. Each of the other 5-i throws is connected to one of the antenna ports 30_k, where k>i i.e. k= i+1, i+2....4. One of the poles is connected to the power amplifier 20_i. Each of the other i-1 poles is connected to one of the throws from respective switches 20_p, where p<i i.e. p= i-1, i-2....1.

It will therefore be appreciated that in at least some examples, the apparatus 10 is configured to control 40 a switching arrangement 42 between the plurality of power amplifiers 20_i and the multiplicity of antenna ports 30_j, wherein the switching arrangement 42 is configured to connect each of the plurality of power amplifiers 20_i to at least one antenna port 30_j and at least a first one of the plurality of power amplifiers 20_i to any one of multiple different of the multiplicity of antenna ports 30_j, wherein the first one of the plurality of power amplifiers 20_i has the greatest maximum output power capability 22_i amongst the plurality of power amplifiers 20_i.

The controller 40 is configured to switch 42_i a power amplifier 20_1 having a greatest maximum output power capability 22_1 amongst the plurality of power amplifiers 20_i to any one of a first number of the multiplicity of antenna ports 30_i and a power amplifier 20_N that has the lowest maximum output power capability 22_N amongst the plurality of power amplifiers 20_i to any one of a second number of the multiplicity of antenna ports 30_j, wherein the first number is the maximum number of antenna ports 30_j to which any of the plurality of power amplifiers 20_i is switchable and the second number is a minimum number of antenna ports 30_j to which any of the plurality of power amplifiers 20_i is switchable.

The highest output power capable power amplifier 20_1 can be switched to any of the antenna ports. The lowest output power capable power amplifier 20_N can be switched to only the antenna port 30_N.

The power amplifier 20_1 with the largest maximum output power capability 22_1 has the most antenna ports 30_j available and the smallest maximum output power capability 22_N power amplifier 20_N has the least antenna ports 30_j available.

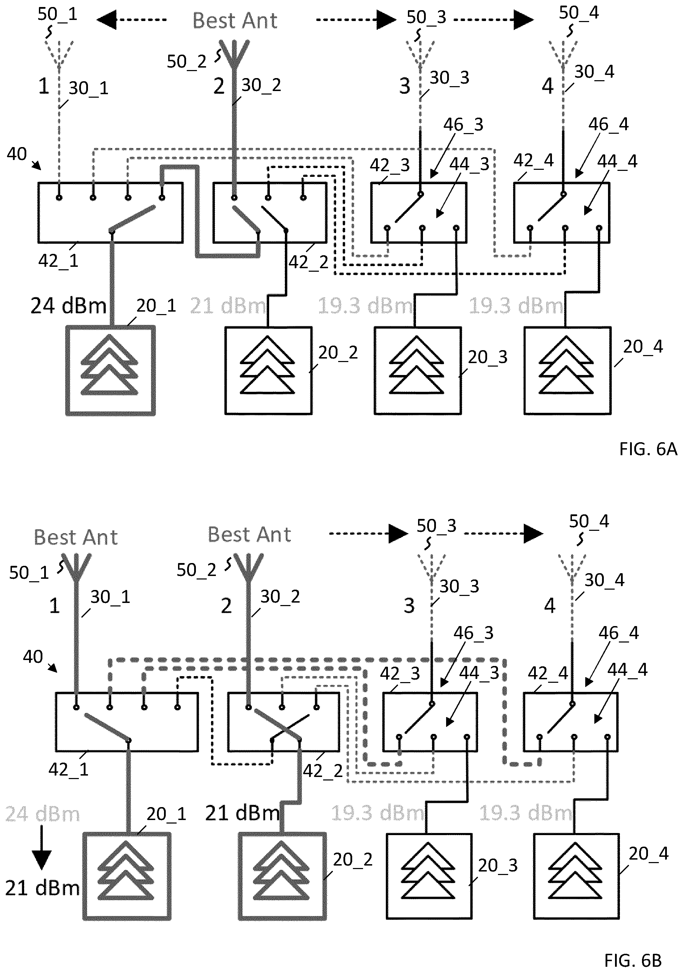

The examples illustrated in FIGs 6A to 6F are similar to FIGs 4 and 5. However, in this example, there are multiple lowest output power capability power amplifiers 20_3, 20_4. There is not a throw 46_3 for the switch 42_3 that connects to a pole 44_4 of the switch 42_4. The switches 42_3 and 42_4 are arranged in parallel and present alternative switching options for the power amplifiers 20_1, 20_2. However, switch 42_4 does not present an alternative switching option for the power amplifiers 20_3. Each of the multiple lowest output power capability power amplifiers 20_3, 20_4 each have a single respective antenna option shared as an option for one or more higher output power capability power amplifiers 20_1, 20_2. The lower output power capability power amplifier needs less antenna options. This example, reduces complexity in switch 42_3 when the PA efficiency "gains" start to diminish as the output power capability drops.

FIGs 6A to 6F illustrate operation of the apparatus 10 for MIMO operation of different rank. In these examples, the power amplifier 20_1 has a maximum output power capability level P_1 of 24dBm. In these examples, the power amplifier 20_2 has a maximum output power capability level P_1 of 24dBm - 10log2 dBm = 21dBm. In these examples, the power amplifier 20_3 and the power amplifier 20_4 has a maximum output power capability level P_1 of 24dBm - 10log3 dBm = 19.3 dBm.

In each of the FIGs 6A to 6F the same combined total transmit power target (T) of 24dBm is obtained.

In FIG 6A, MIMO rank 1 is achieved using one uplink transmission by the power amplifier 20_1 at 24dBm (zero backoff). Any one of the antennas 50 can be used. The best antenna 50 can therefore be used. Where path losses are estimated, the selection between the alternative antennas can additionally or alternatively be based on the estimated path losses, which reduce backoff. For example, it may be routed as close as possible to the power amplifier 20_1 for insertion loss minimization.

In FIG 6B, MIMO rank 2 is achieved using uplink transmission by the power amplifier 20_1 at 21dBm (backoff of 10log2 dB= 3 dB) and uplink transmission by the power amplifier 20_2 at 21dBm (zero backoff). Any one of the higher indexed (i=3, 4) antennas 50 that is not used by the power amplifier 20_1 can be used. The best antenna 50 can therefore be used. Where path losses are estimated, the selection between the alternative antennas can additionally or alternatively be based on the estimated path losses, which reduce backoff.

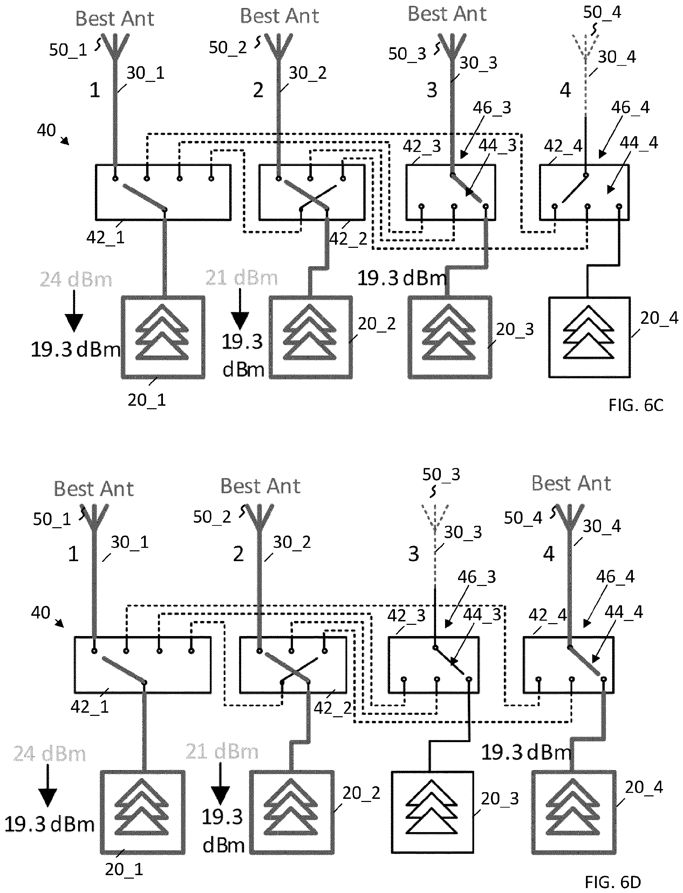

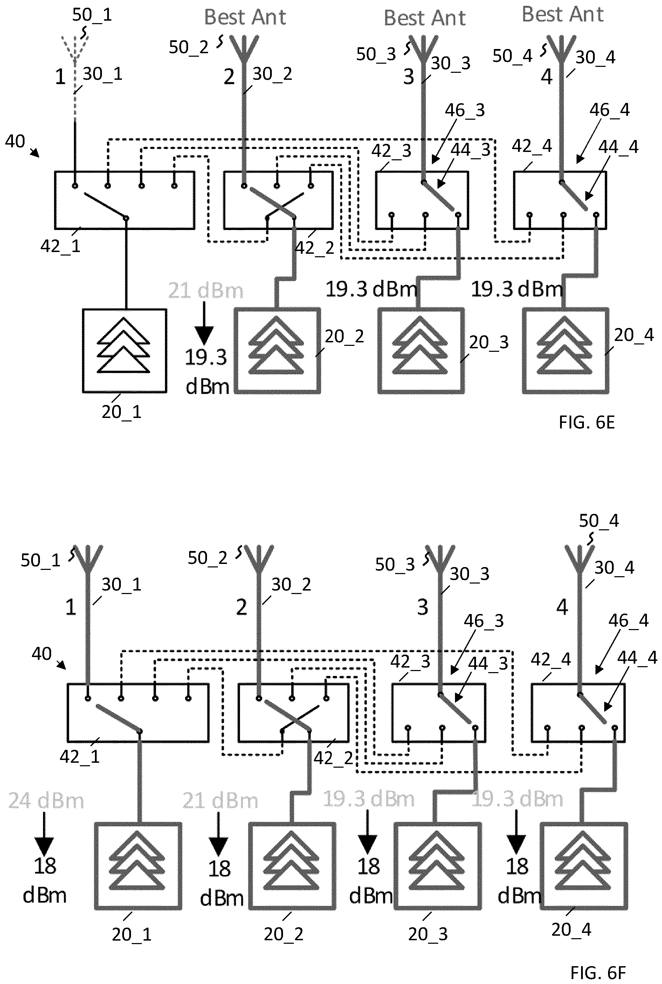

In FIGs 6C, 6D, 6E, MIMO rank 3, is achieved using uplink transmission by three power amplifiers 20 at 19.3 dBm.

In FIGs 6C, this is achieved using uplink transmission by the power amplifier 20_1 at 19.3 dBm (backoff of 4.7 dB), uplink transmission by the power amplifier 20_2 at 19.3 dBm (backoff of 1.7 dB) and uplink transmission by the power amplifier 20_3 at 19.3dBm (zero backoff). The total combined back-off is 6.4 dB. The maximum power backoff is 4.7dB.

In FIGs 6D, this is achieved using uplink transmission by the power amplifier 20_1 at 19.3 dBm (backoff of 4.7 dB), uplink transmission by the power amplifier 20_2 at dBm (backoff of 1.7 dB) and uplink transmission by the power amplifier 20_4 at 19.3dBm (zero backoff). The total combined back-off is 6.4 dBm. The maximum power backoff is 4.7dB.

In FIGs 6E, this is achieved using uplink transmission by the power amplifier 20_2 at 19.3 dBm (backoff of 1.7 dB), uplink transmission by the power amplifier 20_3 at dBm (zero backoff) and uplink transmission by the power amplifier 20_4 at 19.3dBm (zero backoff). The total combined back-off is 1.7 dBm. The maximum power backoff is 1.7dB.

Assuming equal path losses, the selection between the alternative configurations shown in FIGs 6C, 6D, 6E for MIMO rank 3 can be based on different selection criteria.

In one example, the configuration with the minimum total combined power back-off is selected (FIG 6E).

In one example, the configuration with the minimum backoff is selected (FIG 6E).

In one example, the antenna 50_4 is unusable because of transmission channel loss, for example from hand-shielding. The configuration that does not use antenna 50_4 is selected (FIG 6C).

In one example, the antenna 50_3 is unusable because of transmission channel loss, for example from hand-shielding. The configuration that does not use antenna 50_3 is selected (FIG 6D).

In other examples, where path losses are estimated, the selection between the alternative configurations shown in FIGs 6C, 6D, 6E for MIMO rank 3 can additionally or alternatively be based on the estimated path losses, which reduce power backoff.

In FIG 6F, MIMO rank 4 is achieved using uplink transmission by the power amplifier 20_1 at 18dBm (backoff of 10log4 dB= 6 dB), uplink transmission by the power amplifier 20_2 at 18dBm (backoff of 3 dB), uplink transmission by the power amplifier 20_3 at 18dBm (backoff of 1.3 dB) and uplink transmission by the power amplifier 20_4 at 18dBm (backoff of 1.3 dB)

It will therefore be appreciated that the controller 40 is configured to select a set 60 of one or more power amplifiers 20_i from the plurality of power amplifiers 20_i for use with respective antenna ports 30_j in response to a requirement to increase the number of antenna ports 30_j in use.

In these examples, the controller 20 is configured to select for addition to the set 60 of one or more power amplifiers 20_i an additional power amplifier 20_i from the remaining power amplifiers 20_i of the plurality of power amplifiers 20_i that are not presently in the set 60, wherein the selected additional power amplifier 20_i is the power amplifier 20_i of the remaining power amplifiers 20_i that has the lowest maximum output power capability 22_i amongst the remaining power amplifiers 20_i.

This operation is illustrated by the transition from FIG 6B to FIG 6C. In order to increase the number of uplinks, the power amplifier 20_3 is added to the set 60.

This operation is illustrated by the transition from FIG 6B to FIG 6D. In order to increase the number of uplinks, the power amplifiers 20_4 is added to the set 60.

This operation is illustrated by the transition from FIG 6B to FIG 6E. In order to increase the number of uplinks, the power amplifier 20_1 is removed from the set 60 and the power amplifiers 20_3, 20_4 are added.

The reverse operation, on moving to a smaller number of members in the set 60 (less UL Tx) can de-select a power amplifier 20 other than the power amplifier 20_i with the lowest maximum output power capability 22. This operation is illustrated by the transition from FIG 6F to FIG 6E. In order to decrease the number of uplinks, the power amplifier 20_1 is removed from the set 60.

In transition from rank 3 to rank 2, the target transmit power can only be achieved using the power amplifier 20_1 and the power amplifier 20_2. It cannot be achieved by any other combination of 2 power amplifiers. The constraint of meeting the target transmit power T (23dBm) therefore constrains the selection to the power amplifiers 20_1, 20_2 only.

Subject to such constraints the controller 40 switches-in additional power amplifiers with higher maximum output power capability 22_i as the demand increases and switches-out the current power amplifier with lowest maximum output power capability 22_i as the demand increases.

Referring to FIG 6A, it can be noticed that in this example, one of the plurality of power amplifiers 20_1 meets, by itself, the maximum output power requirement (T) which is controllable via downlink control signaling by the cellular telecommunications network. One power amplifier 20_1 meets by itself the maximum output power requirement for a power class and the other power-amplifiers have reduced maximum output power capability.

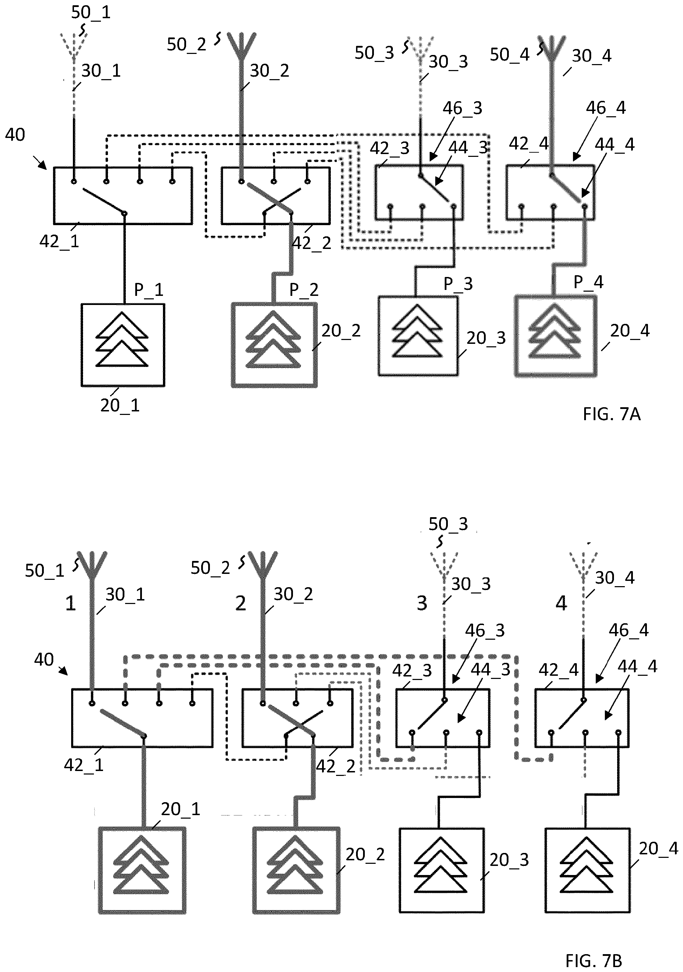

FIGs 7A & 7B illustrates an example of operation of the controller 40 when there is a change in maximum output power requirement (T). In some examples, this is controllable via downlink control signaling by the cellular telecommunications network.

In FIG 7A, there is MIMO rank 2 operation. The power amplifier 20_2 is transmitting via antenna element 30_2 and the power amplifier 20_4 is transmitting via antenna element 30_4. The power amplifier 20_1 and the power amplifier 20_3 are not transmitting. The maximum output power requirement (T) is P_2 + P_4 which is less than P_1 + P_2 but greater than P_3 + P_4.

In FIG 7B, there is MIMO rank 2 operation. The power amplifier 20_1 is transmitting via antenna element 30_1 and the power amplifier 20_2 is transmitting via antenna element 30_2. The power amplifier 20_3 and the power amplifier 20_4 are not transmitting. The maximum output power requirement (T) is P_1 + P_2 which is greater than P_2 + P_4.

In this example P_3 = P_4 as previously described.

When the maximum output power requirement (T) increases beyond the maximum output power capability of the current set 60, then the controller 40 selects a new optimal set of power amplifiers 20 and antenna ports 30 as previously described.

When the maximum output power requirement (T) decreases below the maximum output power capability of a putative set 60 that is next-lowest after the maximum output power capability of the current set 60, then the controller 40 selects a new optimal set of power amplifiers 20 and antenna ports 30 as previously described.

Thus, considering FIG 7A, when the maximum output power requirement (T) increases beyond the maximum output power capability of the current set 60 (P_2 + P_4), then the controller 40 selects a new optimal set of power amplifiers 20 and antenna ports 30 as previously described. The configuration illustrated in FIG 7B which has the next-highest maximum output power capability of a putative set 60 of the same rank (P_1 + P_2).

Thus, considering FIG 7B, when the maximum output power requirement (T) decreases below the putative maximum output power capability of a putative set 60 that is next-lowest after the maximum output power capability of the current set 60 i.e. reduces to P_2 + P_3 then the controller 40 selects a new optimal set of power amplifiers 20 and antenna ports 30 as previously described. For example, the configuration illustrated in FIG 7A which has the next-lowest highest maximum output power capability of a putative set 60 of the same rank (rank 2), can be selected. The rank 2 configuration illustrated in FIG 7A has a highest maximum output power capability of P_2 + P_4 which is the next-lowest for a rank 2 configuration after the highest maximum output power capability of P_1 + P_2 for the rank 2 configuration illustrated in FIG 7B.

It will be appreciated that in some examples, the controller 40 is configured to replace a power amplifier 20_i in the set 60 of one or more power amplifiers 20_i in response to a requirement to increase the combined total transmit power of the set 60, only if the output power of the power amplifier 20_i, for replacement, has been maximized. The power amplifier 20_i that is replaced will be the or one of the least output power capable power amplifiers (depending on path loss). It will be replaced in the set 60 by a more output power capable power amplifier. The assignment of power amplifiers to antenna 50s_i may change.

The network can request an increase in the maximum output power requirement (T) for a user equipment, for example to provide greater range. Once the maximum output power requirement (T) request from the network exceeds the maximum output power capability of the current selected set 60 of power amplifiers 20, the apparatus will transfer an UL signal from the lowest output power capable power amplifier 20 to the next greatest output power capable power amplifier 20. This is repeated up, as necessary until the appreciated maximum output power requirement (T) is met or the apparatus 10 is using the most output power capable power amplifier 20.

In current 5G implementations, for each antenna 50, the power amplifier 20 is designed to deliver at least 23 dBm at the antenna port 30 in a power class 3 (PC3) user equipment (UE) type of device.

When multiple power amplifiers 20 are used simultaneously then the power at each antenna 50 is reduced to maintain compliance with the PC3 requirements. The power amplifiers (PAs) 20 can therefore be operated with backoff and the amount of back-off increases with increasing numbers of simultaneously used power amplifiers 20.

To fulfil the 23 dBm total output power at antennas in a multi-UL MIMO application, the output power for each transmitter branch must be backed-off compared to the optimum maximum output power the PA is designed for. This is not efficient for PAs 20 despite the existence of several assisted schemes to improve PA efficiency.

There is a desire to meet demand for higher uplink bandwidth while keeping the design within attractive current consumption numbers when introducing more transmission paths for the same frequency range by adding more power amplifiers.

At least some examples improve UE power consumption efficiency in multi-UL MIMO (in 6G) by allowing the UE to use PAs 20 with lower maximum output power capability 22 thereby avoiding unnecessary efficiency degrading power backoff 28.

The apparatus 10 is configured for but not limited to 6G frequencies, for example 7GHz-20 GHz where the PAs 20 are designed for MIMO purposes and an intelligent distribution scheme takes care of fulfilling the legacy 1-Tx UL maximum power and best antenna selection (BAS) features while enhancing MIMO and CA/DC efficiency in terms of UE current consumption.

Once the UE 10 receives an uplink grant or request it will apply the power distribution scheme to compare the UE-supported power amplifier connections to antennas. The apparatus 10 will then avoid unnecessary power back-off 28 in its uplink configuration while fulfilling maximum output power requirements (meeting the combined transmit power target T). The presented hardware architecture is applicable to any frequency range but serves best where single antenna elements 50 are used (not an array). Additionally, the presented architecture brings the same output power relaxations within the use and assignment of PAs 20 to carrier aggregation and dual connectivity cases. The apparatus 10 can select the best suitable antennas 50 for evaluation based on DL signals (avoiding user-blocked antennas 50).

The advantages provided include:
(a) cost, size, and power consumption optimized UE transmitter apparatus 10 that supports legacy 1-TX, UL CA, and UL MIMO operation,
(b) best TX power exploitation of PAs 20 through novel switching and control method,
(c) the proposal gets the benefit of the existing switches designed for SRS (Sounding Reference Signal), so SRS is an integrated part of the proposed architecture,
(d) PA technology agnostic design for low TX power (<19 dBm / a threshold), low current consumption design,
(e) if the required UE transmitter power for 1-TX uplink is below 19 dBm / a threshold, then we need to turn on only one "optimized" PA chain,
(f) UE optimizes the uplink hardware configuration based on its own hardware capability and antenna routing,
(g) the presented hardware architecture and output power control method is applicable and advantageous in CA and EN/DC configurations as well (Interband operation), and
(h) a customized switch design with only 1 RF (radio frequency) line between each antenna.

FIG 4 shows the proposed general front-end RF architecture of apparatus 10 for multi-UL MIMO. The switches 42 at the PAs outputs can be designed as part of the existing sounding reference signal (SRS) switching which means our proposal does not add extra power loss compared to existing design trends, since loss after the power amplifier 20 is undesired.

PAs 20 of different output power capability are used. This provides for a major improvement in cost, size, and power efficiency (less current consumption) for the UE's transmitter, since a lower output power from PA 20 means less current and less heat and thus enables the use of smaller transistors with a reduced footprint. This is an advantage for devices in the existing 5G spectrum but especially relevant for devices in the proposed new 6G frequency range of 7-15 GHz. The concept can be re-configured if the UE supports a lower or higher number of UL-MIMO.

A strip-down of the general concept to a 4-UL MIMO is illustrated in FIG 5.

The apparatus 10 has an optimized architecture for minimizing the number of "pins" of the switch connected to antenna 50_3 and 50_4 and consequently reducing loss.

FIG 6A-6F illustrate MIMO. An output power target of 24 dBm at PA output is used for the exemplary case in the figure, but it may be adapted to any output power level that a communication system allows. The example here assumes a 1 dB path loss to the antenna of the shortest routing for each PA module. The output power levels shown at the PAs 20 are not the active state, but the maximum output power capability of the individual PAs 20.

The apparatus 10 has an optimized architecture for minimizing the number of "pins" of the switch connected to antenna 30_3 and 50_4 and consequently reduction of loss. The proposed architecture allows using one power amplifier with a 3 dB lower maximum output power capability and two power amplifiers with approximately 5dB lower maximum output power capability while fulfilling all the requirements of legacy architectures.

FIG 6A is a MIMO rank-1, 1-layer UL Tx. The UE 10should be able to both fulfil the 3GPP maximum power requirement of 23 dBm at its antenna and achieve the Best Antenna Selection (BAS) feature. BAS is not a 3GPP requirement but most of the existing high-end smartphones use this application for coverage enhancement. Therefore, the proposed architecture in this example includes one highest output power capable power amplifier 20_1 which can be switched to any one of all available antennas 50_i of the operating band to support the BAS feature. As default, this power amplifier 20_1 is connected to antenna 50_1 which will be routed as close as possible to this power amplifier for insertion loss reduction.

FIG 6B illustrates MIMO rank-2, 2-layer UL Tx. For the 2-UL MIMO application, the power amplifier 20_1 with the highest output power level capability i.e., 24 dBm, is backed-off to 21 dBm and is as default connected to antenna 50_1 (which will be routed optimally for this antenna). The PA 20_2 with the second highest output power level capability i.e., 21dBm, is as default connected to antenna 50_2 (which will be routed optimally for this antenna). With a second PA 20_2 designed for a maximum 21dBm, the efficiency of this PA 20_2 will be better at 21dBm, than the efficiency of the PA 20_1 at antenna 50_1 backed-off to 21 dBm. PA 20_1 can be switched to either antenna 50_2, 50_3 or 50_4 and the power amplifier 20_2 can be switched to either antenna 50_3 or antenna 50_4. The order of priority of shifting antennas in 2-UL MIMO is PA 20_1 at antenna 50_1, before PA 20_2 at antenna 50_2. This is because the PA 20_1 at antenna 50_1 will have better compensation for the additional path loss through the additional switch.

FIG 6C to 6E illustrate MIMO rank-3, 3-layer UL Tx. For this application, three power amplifier are operated at 19.3 dBm. In FIG 6C & 6D, the two power amplifiers 20_1, 20_2 with the two highest output power capability are backed-off to 19.3 dBm. The maximum output power capability of the power amplifier 20_1 is 24dBm. The maximum output power capability of the power amplifier 20_2 is 21dBm. In FIG 6E, the power amplifiers 20_1 with the highest output power capability is not used. The power amplifier 20_2 is backed-off from its maximum output power capability Pmax of 21 dBm to 19.3 dBm.

Any three out of four antennas can now be used as 3-UL MIMO dependent on BAS. The most power-efficient configuration is the architecture shown in 6E where only one power amplifier 20_2 is backed-off from a Pmax of 21 dBm to 19.3 dBm. This has the lowest backoff and the configuration has the highest efficiency.

FIG 6F illustrates MIMO rank-4, 4-layer UL Tx.

In relation to uplink carrier aggregation (ULCA) in which two transmitters are active simultaneously, but contrary to UL-MIMO they operate on different frequencies. There are the same output power and implementation advantages in ULCA as in UL MIMO, the PAs 20 will be activated towards the individual antennas 50 based on the same output power control, but linked to the assignment of the primary serving cell (PCell) and the secondary serving cell (Scell) accordingly.

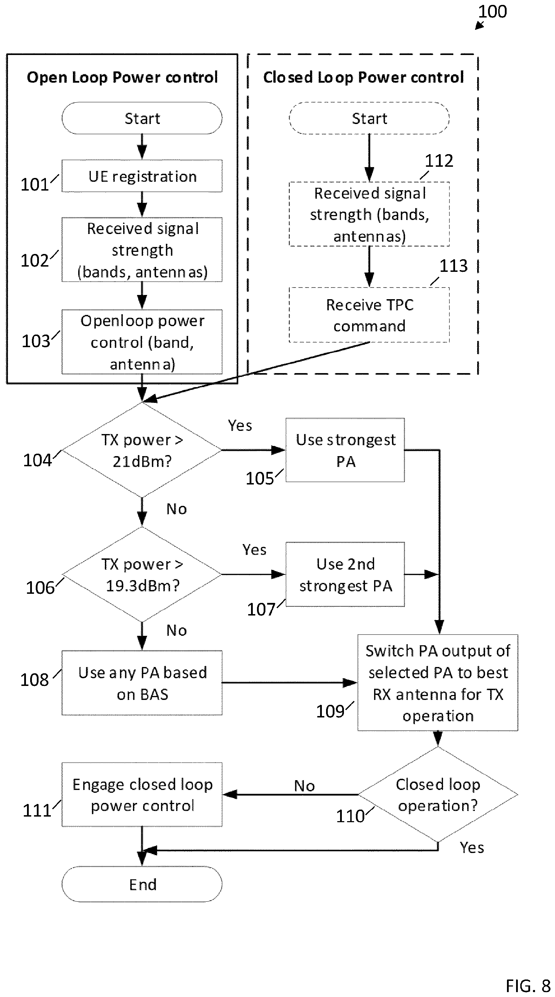

FIG 8 illustrates a power control method 100. The method has advanced control and configuration of the new different PA capabilities, in the sense that the PAs 20 may transmit at different power levels, with different impacts on current consumption and heating. The method 100 relies on the change in configuration of the PAs 20 based on the TX power regions where the most power-capable PA 20 dominates. As the requested output power level drops the most power-capable PA 20 hands over the operation to the second most power-capable PA 20 in line on output power capability. This is shown in Fig 8.

Referring to FIG 8, at block 101, the apparatus 10 (the UE) registers on the network (NW) the following standard procedures.

At block 102, the UE 10 determines the active bands of operation in the network and measures the input signal strength by all metrics available within the system to indicate received signal power from the network.

At block 103, open loop power control is activated and determines the transmit signal strength of the UE 10, based on the received signal strength indicating the UE to NW least path loss. At block 104, the UE 10 checks according to the implemented PAs if the output power response is only achievable at the "strongest" PA.

If this is the case, the UE 10 configures 105 the strongest PA accordingly.

If this is not the case the UE 10 checks 106 if the output power response is achievable using the second "strongest" PA.

If this is the case, the UE 10 configures the second strongest PA accordingly.

If this is not the case, the UE 10 may configure any PA that is most suitable for transmission according to the received signal strength at any antenna (BAS).

Then at block 109, the UE 10 switches the selected PA to the best antenna 50.

If the UE 10 is in open loop mode it engages closed loop power control 112 in step 111, otherwise the routine ends awaiting the next output power change request 113.

If the UE is in closed loop mode the UE 10 maintains tracking the antennas for best reception, thereby determining where to transmit in response towards the network.

At every Transmission Power Control (TPC) command 113 that alters the output power of the UE, the apparatus 10 repeats the blocks 104 to 111.

The flowchart can be applied to any amount of uplink transmitters including PAs towards any number of antennas. It may have different threshold levels for the checks 104, 106 that determine which PA 20 to use, the numbers in the FIG 8 are simply to make the exemplary case. The control flow of FIG 8 applies in both UL-MIMO and ULCA.

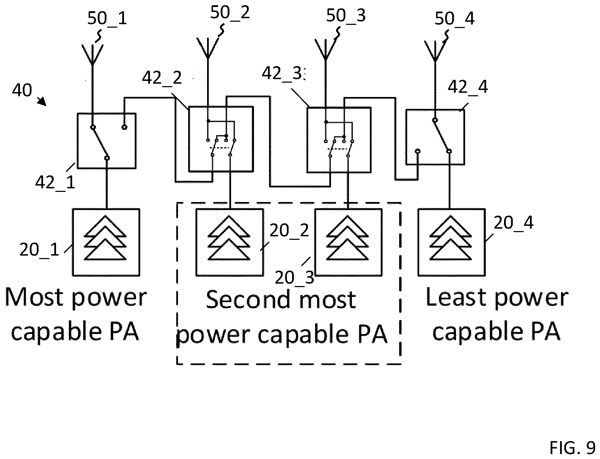

FIG 9 illustrates an apparatus 10 that has further simplified RF tracks between the antennas 50. In this example, a single-track interconnects switch 42_1 and switch 42_2 and a single-track interconnects switch 42_2 and switch 42_3 and a single track interconnects switch 42_3 and switch 42_4. In this example, the apparatus 10 has two of the second most output power capable power amplifiers 20-2, 20_3 connected via the respective switches 20_2, 20_3.

The antenna 50_i is connected to a throw of a nearby switch 42_i. The power amplifier 20_i is connected to a pole of the 1P2T (SPDT) switch 42_1.

The antenna 50_1 is connected to a throw of a SPDT switch 42_1. The antenna 50_2 is connected to a throw of a DPDT switch 42_2. The antenna 50_3 is connected to a throw of a DPDT switch 42_3. The antenna 50_4 is connected to a throw of a SPDT switch 42_4.

A throw of the SPDT switch 42_1 is connected to a pole of the 2P2T (DPDT) switch 42_2. A throw of the DPDT switch 42_2 is connected to a pole of the 2P2T (DPDT) switch 42_3. A throw of the DPDT switch 42_3 is connected to a pole of the 2P1T (DPST) switch 42_4.

For rank 1 operation, the power amplifier 20_1 can be routed to any one of the antennas 50_i. The power amplifier 20_2 can be routed to any one of the antennas 50_2, 50_3, 50_4. The power amplifier 20_3 can be routed to any one of the antennas 50_3, 50_4 The power amplifier 20_4 can be routed to only the antenna 50_4.

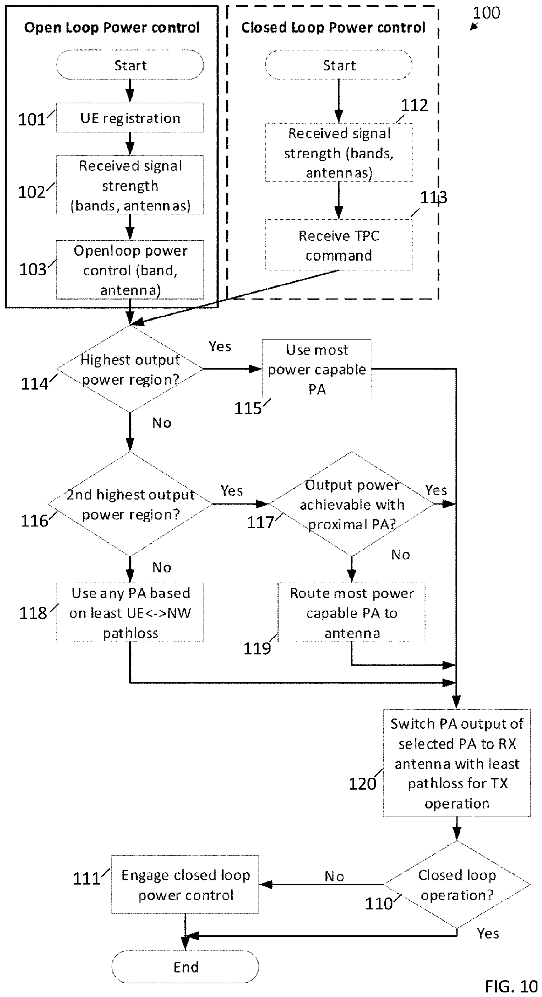

The hardware implementation of FIG 9 follows a different power control flow than presented in FIG 8 which is shown in FIG 10.

At block 101, the apparatus 10 (the UE) registers on the network (NW) following standard procedures.

At block 102, the UE 10 determines the active bands of operation in the network and measures the input signal strength by all metrics available within the system to indicate received signal power from the network.

At block 103, open loop power control is activated and determines the transmit signal strength of the UE 10, based on the received signal strength indicating the UE to NW least path loss. At block 114, the UE 10 checks according to the implemented PAs if the output power response is only achievable at the "strongest" PA, i.e. the highest output power region is required.

If this is the case, the UE 10 configures 115 the strongest, most output power capable PA accordingly.

If this is not the case the UE 10 checks 116 if the output power response is achievable using a second "strongest" PA i.e. the second highest output power region is required.

If this is the case, the UE 10 configures one of the second strongest PAs accordingly and if not, the method moves to block 118.

For example, it is determined at block 117 if the output power is achievable using a power amplifier proximal to a best antenna element. If so that proximal power amplifier is used. If not, the most output power capable PA is routed to the best antenna element.

At block 118, the UE 10 may configure any PA that is most suitable for transmission according to the received signal strength at any antenna (BAS).

Then at block 120, the UE 10 switches the selected PAs to the best antennas 50.

If the UE 10 is in open loop mode it engages closed loop power control 112 in step 111, otherwise the routine ends awaiting the next output power change request 113.

If the UE is in closed loop mode the UE 10 maintains tracking the antennas for best reception, thereby determining which PAs and antennas are selected for transmission in response towards the network.

The proximal PA 20 as described is considered the PA 20 subject to the least insertion loss towards the antenna. It is typically a PA 20 in the vicinity of the antenna and needing only a single switch throw to reach the antenna.

The most power capable PA 20 is routed to the antenna not able to reach the second highest output power region.

In the prior art, for each antenna, a power amplifier is designed to deliver at least 23 dBm at the antenna reference point (antenna port) in a power class 3 (PC3) UE type of device. When the device supports 2UL MIMO, then the power at each antenna is reduced to maintain compliance with the PC3 requirements unless the UE declares PC2 (26dBm). Similar reductions in absolute output power applies if more than one uplink component carrier is configured. The combined power of both uplink component carriers must comply with the power class limit.

The following description targets optimum power amplifier (PA) 20 configuration towards output power in single layer operation, which uses just one PA.

PA output power is based on matching the required output power levels according to power class. Output power relates to the measured level at the antenna port, which means a 23dBm Power Class 3 PA must output a level of 23dBm + front-end path loss due to filters, switches, matching, tuning, and routing elements, i.e. any component and/or connection in the conducted path between the PA output pin and an antenna port or antenna feed point.

The output power control method needs to account for antenna assignment in multi-transmission modes.

The controller 40 is configured to route the PA output (UL signal) to the antenna showing the best channel conditions of the DL, depending on the potential CA/ EN-DC primary cell assignment.

That means that if one antenna 50 has best channel conditions for two different bands of operation the UE 10 will choose to place the primary component carrier at the best antenna. Next the UE must account for pathloss towards the antennas. Typically, calibration secures that the PA 20 delivers the correct output power level at the antenna port 30.

The UE 10 is calibrated for each PA 20 at the antenna port 30 with least insertion loss, while each PA 20 additionally is measured for delta power on other configurable antenna ports 40 the PA 20 may be routed to.

For single component carrier operation, and the optimum output power utilization, the UE 10 will apply the least output power capable PA up to its maximum of absolute power level. Once the output power requests from the network exceeds the capability of the PA 20 the UE 10 will transfer the UL signal to the next output power capable PA 20 up until the UE 10 is using the most output power capable PA 20 for uplink transmission provided the network continues to request output power increase.

For the UE to apply the optimum PA 20 for meeting the output power request the UE 10 estimates the pathloss for each PA 20 to each antenna 50 that the controller routing allows support towards. The pathloss for each PA 20 to each supported antenna 50 is stored in UE memory as part of UE output calibration in production. The calibration can be done for:
- Each band.
- Each PA 20.
- In frequency steps to add frequency dependency (frequency ripple response).
- Each antenna port served by an individual PA 20.
- Optionally across output power level if impedance matching detunes the PA.
- Data may be stored based on feedback receiver levels.
- Data may be stored based on uplink output power configuration register settings.
- Data may be stored based on analogue level adjustments.

The UE 10 can configure the Tx uplink path based on:
- Determining the maximum output power level for each PA 20.
- Determining the best antenna 50, based on Rx input power/quality of same operational band.
- Determining which PA 20 can serve the output power request, prioritized from least output power-capable PA and up, including maximum output power capability and best antenna additional path loss (calibration).

The power antenna 20_i has a maximum output power capability P_i. The antenna 40_j has a transmission channel loss T_j. The path 42ij from the power amplifier 20_i to the antenna 50_j has a power loss L_ij.

Consider the metric Zij, where Zij= P_i - L_iy -T_y for each i, j.

The controller can select a power amplifier 20_i and an antenna element 50_j by identifying the PA 20_i that is usable and has the lowest possible maximum output power capability, for example what is the column in the table below that can support the required power that has the highest index i. Then the controller 40 selects the best possible antenna index j for that index, for example, what is the best row in that column. This identifies the highest output power capability at the antenna with least loss.

| P_i w/o losses | 18 | 19.2 | 21 | 24 |
|---|---|---|---|---|
| Zij: w/losses (path Lij and channel j) | i=4 | =3 | =2 | =1 |
| j=1 | 13.9 | 15.2 | 16.9 | 20.4 |
| =2 | 14.95 | 16.25 | 18.3 | 21.2 |
| =3 | **17.05** | **18.3** | **20.05** | **23.1** |
| =4 | 12.2 | 13.25 | 14.95 | 18.05 |

Applying this algorithm to the table above produces the following pairs (i, j) for PA 20_i index i and antenna 50_j index j for different maximum power requirements T.

| | | | | | | | | | |
|---|---|---|---|---|---|---|---|---|---|
| T: | 15, | 16, | 17, | 18*, | 19*, | 20, | 21*, | 22, | 23 |
| Use: | (4, 3), | (4, 3), | (4,3) | (3,3) | (2, 3) | (2,3) | (1,3) | (1,3) | (1, 3) |

| P_i w/o losses | 18 | 19.2 | 21 | 24 |
|---|---|---|---|---|
| Zij: w/losses (path Lij and channel j) | l=4 | =3 | =2 | =1 |
| j=1 | 16.4 | 17.7 | 19.4 | 22.9 |
| =2 | 16.85 | 18.15 | **20.2** | **23.1** |
| =3 | 16.85 | 18.1 | 19.85 | 22.9 |
| =4 | **17.2** | **18.25** | 19.95 | 23.05 |

Apply this algorithm to the table above produces the following pairs (i, j) for PA index I and antenna index j for different maximum power requirements T.

| | | | | | | | | | |
|---|---|---|---|---|---|---|---|---|---|
| T: | 15, | 16, | 17, | 18*, | 19*, | 20, | 21*, | 22, | 23 |
| Use: | (4,4), | (4, 4), | (4,4) | (3,4) | (2, 2) | (2,2) | (1,2) | (1,2) | (1, 2) |

| P_i w/o losses | 18 | 19.2 | 21 | 24 |
|---|---|---|---|---|
| Zij: w/losses (path Lij and channel j) | l=4 | =3 | =2 | =1 |
| j=1 | 14.6 | 14.9 | 18 | **22.9** |
| =2 | 15.15 | 16.35 | **20** | 22.6 |
| =3 | 15.95 | **18.1** | 18.5 | 21.5 |
| =4 | **17.05** | 16.7 | 16.5 | 20.8 |

Apply this algorithm to the table above produces the following pairs (i, j) for PA index I and antenna index j for different maximum power requirements T.

| | | | | | | | | | |
|---|---|---|---|---|---|---|---|---|---|
| T: | 15, | 16, | 17, | 18*, | 19*, | 20, | 21*, | 22, | 23 |
| Use: | (4,4), | (4, 4), | (4,4) | (3,3) | (2, 2) | (2,2) | (1,1) | (1,1) | (1,1) |

The examples show cases in which the PA selection changes at different output power request states (T). The examples show that a PA 20 may be routed to the same antenna or to a different antenna relative to the output power request. The advantage in this scheme is that the least output power capable PA 20_4 is used to the absolute highest level, before switching on "a larger PA," which means that each of the output power steps towards achieving maximum output power of the supported power class is always done with a focus of using the least power consuming PA at that time.

In uplink multi-band operation, for example carrier aggregation, the UE 10 can prioritize the primary component carrier (PCC). This affects the best antenna selection, since the PCC has uplink priority over the secondary component carrier (SCC). Only uplink configurations with simultaneous transmission of both component carriers in the same timeslot is considered. In multi-carrier configurations the PCC follows the power control scheme described immediately above, while the power control scheme of the SCC must check the PCC antenna choice additionally in the use of PA (Separate front-end components) and the routing of antenna to avoid also choosing the antenna chosen for the PCC.

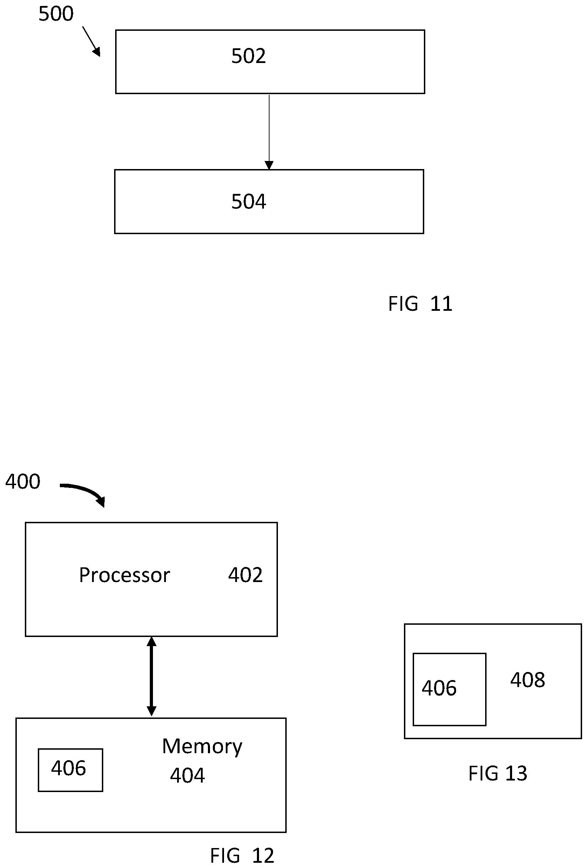

FIG 11 illustrates an example of a method 500 comprising:
At block 502, selecting a set 60 of one or more power amplifiers 20_i from a plurality of power amplifiers 20_i for simultaneous transmission via respective antenna ports 30_j, wherein at least some of the plurality of power amplifiers 20_i have different maximum output power capabilities 22_i.

At block 504, using the selected set 60 of one or more power amplifiers 20_i from the plurality of power amplifiers 20_i for simultaneous transmission via respective antenna ports 30_j.

Fig 12 illustrates an example of a controller 400 suitable for use in an apparatus 10. Implementation of a controller 400 may be as controller circuitry. The controller 400 may be implemented in hardware alone, have certain aspects in software including firmware alone or can be a combination of hardware and software (including firmware).

As illustrated in Fig 12 the controller 400 may be implemented using instructions that enable hardware functionality, for example, by using executable instructions of a computer program 406 in a general-purpose or special-purpose processor 402 that may be stored on a computer readable storage medium (disk, memory etc) to be executed by such a processor 402.

The processor 402 is configured to read from and write to the memory 404. The processor 402 may also comprise an output interface via which data and/or commands are output by the processor 402 and an input interface via which data and/or commands are input to the processor 402.

The memory 404 stores a computer program 406 comprising computer program instructions (computer program code) that controls the operation of the apparatus 10 when loaded into the processor 402. The computer program instructions, of the computer program 406, provide the logic and routines that enables the apparatus to perform the methods illustrated in the accompanying Figs. The processor 402 by reading the memory 404 is able to load and execute the computer program 406.

The apparatus 10 comprises:
at least one processor 402; and
at least one memory 404 storing instructions that, when executed by the at least one processor 402, cause the apparatus at least to:
   select a set 60 of one or more power amplifiers 20_i, from a plurality of power amplifiers 20_i, for simultaneous transmission via respective antenna ports 30J, wherein at least some of the plurality of power amplifiers 20_i have different maximum output power capabilities 22_i.

As illustrated in Fig 13, the computer program 406 may arrive at the apparatus 10 via any suitable delivery mechanism 408. The delivery mechanism 408 may be, for example, a machine readable medium, a computer-readable medium, a non-transitory computer-readable storage medium, a computer program product, a memory device, a record medium such as a Compact Disc Read-Only Memory (CD-ROM) or a Digital Versatile Disc (DVD) or a solid-state memory, an article of manufacture that comprises or tangibly embodies the computer program 406. The delivery mechanism may be a signal configured to reliably transfer the computer program 406. The apparatus 10 may propagate or transmit the computer program 406 as a computer data signal.

Computer program instructions for causing an apparatus to perform at least the following or for performing at least the following:
selection of a set 60 of one or more power amplifiers 20_i, from a plurality of power amplifiers 20_i, for simultaneous transmission via respective antenna ports 30_j, wherein at least some of the plurality of power amplifiers 20_i have different maximum output power capabilities 22_i.

The computer program instructions may be comprised in a computer program, a non-transitory computer readable medium, a computer program product, a machine readable medium. In some but not necessarily all examples, the computer program instructions may be distributed over more than one computer program.

Although the memory 404 is illustrated as a single component/circuitry it may be implemented as one or more separate components/circuitry some or all of which may be integrated/removable and/or may provide permanent/semi-permanent/ dynamic/cached storage.

Although the processor 402 is illustrated as a single component/circuitry it may be implemented as one or more separate components/circuitry some or all of which may be integrated/removable. The processor 402 may be a single core or multi-core processor.

References to 'computer-readable storage medium', `computer program product', 'tangibly embodied computer program' etc. or a 'controller', 'computer', 'processor' etc. should be understood to encompass not only computers having different architectures such as single /multi- processor architectures and sequential (Von Neumann)/parallel architectures but also specialized circuits such as field-programmable gate arrays (FPGA), application specific circuits (ASIC), signal processing devices and other processing circuitry. References to computer program, instructions, code etc. should be understood to encompass software for a programmable processor or firmware such as, for example, the programmable content of a hardware device whether instructions for a processor, or configuration settings for a fixed-function device, gate array or programmable logic device etc.

As used in this application, the term 'circuitry' may refer to one or more or all of the following:
(a) hardware-only circuitry implementations (such as implementations in only analog and/or digital circuitry) and
(b) combinations of hardware circuits and software, such as (as applicable):
   (i) a combination of analog and/or digital hardware circuit(s) with software/firmware and
   (ii) any portions of hardware processor(s) with software (including digital signal processor(s)), software, and memory or memories that work together to cause an apparatus, such as a mobile phone or server, to perform various functions and
(c) hardware circuit(s) and or processor(s), such as a microprocessor(s) or a portion of a microprocessor(s), that requires software (for example, firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor and its (or their) accompanying software and/or firmware. The term circuitry also covers, for example and if applicable to the particular claim element, a baseband integrated circuit for a mobile device or a similar integrated circuit in a server, a cellular network device, or other computing or network device.

The blocks illustrated in the accompanying Figs may represent steps in a method and/or sections of code in the computer program 406. The illustration of a particular order to the blocks does not necessarily imply that there is a required or preferred order for the blocks and the order and arrangement of the block may be varied. Furthermore, it may be possible for some blocks to be omitted.

Where a structural feature has been described, it may be replaced by means for performing one or more of the functions of the structural feature whether that function or those functions are explicitly or implicitly described.

An operational resonant mode (operational bandwidth) is a frequency range over which an antenna can efficiently operate. An operational resonant mode (operational bandwidth) may be defined as where the return loss S11 of the antenna 20 is greater than an operational threshold T_op such as, for example, 3 or 4 dB and where the radiated efficiency (er) is greater than an operational threshold such as for example -3dB in an efficiency plot. Radiation efficiency is the ratio of the power delivered to the radiation resistance of the antenna (Rrad) to the total power delivered to the antenna: er = (Rrad)/(RL + Rrad), where RL = loss resistance (which covers dissipative losses in the antenna itself). It should be understood that "radiation efficiency" does not include power lost due to poor VSWR (impedance mismatch losses in the matching network which is not part of the antenna as such, but an additional circuit). The "total radiation efficiency" comprises the "radiation efficiency" and power lost due to poor VSWR [in dB]. The efficiency operational threshold could alternatively be expressed in relation to "total radiation efficiency" rather than "radiation efficiency".

As used here 'module' refers to a unit or apparatus that excludes certain parts/components that would be added by an end manufacturer or a user. The apparatus 10 can be a module.

The above-described examples find application as enabling components of:
automotive systems; telecommunication systems; electronic systems including consumer electronic products; distributed computing systems; media systems for generating or rendering media content including audio, visual and audio visual content and mixed, mediated, virtual and/or augmented reality; personal systems including personal health systems or personal fitness systems; navigation systems; user interfaces also known as human machine interfaces; networks including cellular, non-cellular, and optical networks; ad-hoc networks; the internet; the internet of things; virtualized networks; and related software and services.

The apparatus 10 or a module can be implemented in any vehicle (land/air/water borne) either as an add-on or integrated within any part of the vehicle.

The apparatus can be provided in an electronic device, for example, a mobile terminal, according to an example of the present disclosure. It should be understood, however, that a mobile terminal is merely illustrative of an electronic device that would benefit from examples of implementations of the present disclosure and, therefore, should not be taken to limit the scope of the present disclosure to the same. While in certain implementation examples, the apparatus can be provided in a mobile terminal, other types of electronic devices, such as, but not limited to: mobile communication devices, hand portable electronic devices, wearable computing devices, portable digital assistants (PDAs), pagers, mobile computers, desktop computers, televisions, gaming devices, laptop computers, cameras, video recorders, GPS devices and other types of electronic systems, can readily employ examples of the present disclosure. Furthermore, devices can readily employ examples of the present disclosure regardless of their intent to provide mobility.

The term 'comprise' is used in this document with an inclusive not an exclusive meaning. That is any reference to X comprising Y indicates that X may comprise only one Y or may comprise more than one Y. If it is intended to use `comprise' with an exclusive meaning then it will be made clear in the context by referring to "comprising only one..." or by using "consisting".

In this description, the wording 'connect', 'couple' and 'communication' and their derivatives mean operationally connected/coupled/in communication. It should be appreciated that any number or combination of intervening components can exist (including no intervening components), i.e., so as to provide direct or indirect connection/coupling/communication. Any such intervening components can include hardware and/or software components.

As used herein, the term "determine/determining" (and grammatical variants thereof) can include, not least: calculating, computing, processing, deriving, measuring, investigating, identifying, looking up (for example, looking up in a table, a database or another data structure), ascertaining and the like. Also, "determining" can include receiving (for example, receiving information), accessing (for example, accessing data in a memory), obtaining and the like. Also, " determine/determining" can include resolving, selecting, choosing, establishing, and the like.

In this description, reference has been made to various examples. The description of features or functions in relation to an example indicates that those features or functions are present in that example. The use of the term 'example' or `for example' or 'can' or 'may' in the text denotes, whether explicitly stated or not, that such features or functions are present in at least the described example, whether described as an example or not, and that they can be, but are not necessarily, present in some of or all other examples. Thus `example', `for example', `can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a', 'an' or 'the' is used in this document with an inclusive not an exclusive meaning. That is any reference to X comprising a/an/the Y indicates that X may comprise only one Y or may comprise more than one Y unless the context clearly indicates the contrary. If it is intended to use 'a', 'an' or 'the' with an exclusive meaning then it will be made clear in the context. In some circumstances the use of `at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The above description describes some examples of the present disclosure however those of ordinary skill in the art will be aware of possible alternative structures and method features which offer equivalent functionality to the specific examples of such structures and features described herein above and which for the sake of brevity and clarity have been omitted from the above description. Nonetheless, the above description should be read as implicitly including reference to such alternative structures and method features which provide equivalent functionality unless such alternative structures or method features are explicitly excluded in the above description of the examples of the present disclosure.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. An apparatus comprising
a plurality of power amplifiers, wherein at least some of the plurality of power amplifiers have different maximum output power capabilities;
a multiplicity of antenna ports;
means for controlling being configured to select a set of one or more power amplifiers from the plurality of power amplifiers for simultaneous transmission via respective antenna ports.

2. An apparatus as claimed in claim 1, wherein the means for controlling is configured to control a combined total transmit power of the set of one or more power amplifiers to be less than or equal to a combined total transmit power target.

3. An apparatus as claimed in claim 1 or 2, wherein the means for controlling is configured to select the set of power amplifiers such that the power amplifiers in the set have different maximum output power capabilities.

4. An apparatus as claimed in claim 1, 2 or 3, wherein the means for controlling is configured to select the set of power amplifiers such that the power amplifiers in the set have lowest maximum output power capabilities sufficient for a combined total transmit power of the set of one or more power amplifiers to meet a combined total transmit power target.

5. An apparatus as claimed in claim 1, 2 or 3, wherein the means for controlling is configured to evenly distribute a combined total transmit power of the set of one or more power amplifiers across the set of one or more power amplifiers, wherein the power amplifiers in the set are controlled to have the same power output simultaneously.

6. An apparatus as claimed in any preceding claim, wherein the means for controlling is configured to select a set of one or more power amplifiers from the plurality of power amplifiers for simultaneous transmission via respective antenna ports and distribute a combined total transmit power of the set of one or more power amplifiers across the set of one or more power amplifiers, to achieve a distribution of a maximum total transmit power target across a number of power amplifiers required that reduces or minimizes backoff from maximum output power capabilities of the power amplifiers.

7. An apparatus as claimed in claim 2, 4, 5 or 6 or any preceding claim dependent upon claim 2, 3 or 5, wherein the combined total transmit power of the set of one or more power amplifiers is determined at the respective antenna ports and includes an estimate of path loss between each power amplifier in the set of one or more power amplifiers and its respective antenna port.

8. An apparatus as claimed in any preceding claim, wherein the means for controlling is configured to replace a power amplifier in the set of one or more power amplifiers in response to a requirement to increase the combined total transmit power of the set, only if the output power of the power amplifier, for replacement, has reached its maximum output power capability.

9. An apparatus as claimed in any preceding claim, wherein the means for controlling is configured to select for addition to the set of one or more power amplifiers an additional power amplifier from the remaining power amplifiers of the plurality of power amplifiers that are not presently in the set, wherein the selected additional power amplifier is the power amplifier of the remaining power amplifiers that has the lowest maximum output power capability amongst the remaining power amplifiers.

10. An apparatus as claimed in any preceding claim, wherein the means for controlling is configured to select an antenna port for each of the power amplifiers in the set of one or more power amplifiers based on an estimate of power loss in transmission channels associated with the antenna ports and/or an estimate of power loss in the paths between the power amplifiers in the set of one or more power amplifiers and the respective selectable antenna ports.

11. An apparatus as claimed in any preceding claim, wherein the means for controlling is configured to control a switching arrangement between the plurality of power amplifiers and the multiplicity of antenna ports, wherein the switching arrangement is configured to connect each of the plurality of power amplifiers to at least one antenna port and at least a first one of the plurality of power amplifiers to any one of multiple different of the multiplicity of antenna ports, wherein the first one of the plurality of power amplifiers has the greatest maximum output power capability amongst the plurality of power amplifiers.

12. An apparatus as claimed in any preceding claim, wherein the means for controlling is configured to switch a power amplifier having a greatest maximum output power capability amongst the plurality of power amplifiers to any one of the a first number of the multiplicity antenna ports and a power amplifier that has the lowest maximum output power capability amongst the plurality of power amplifiers to any one of a second number of the multiplicity of antenna ports, wherein the first number is the maximum number of antenna ports to which any of the plurality of power amplifiers is switchable and the second number is a minimum number of antenna ports to which any of the plurality of power amplifiers is switchable.

13. An apparatus as claimed in any preceding claim comprised in a user equipment configured for communication with a cellular telecommunications network, wherein one or more of the plurality of power amplifiers are configurable for simultaneous uplink transmission to the cellular telecommunications network.

14. A method comprising
select a set of one or more power amplifiers from a plurality of power amplifiers for simultaneous transmission via respective antenna ports, wherein at least some of the plurality of power amplifiers have different maximum output power capabilities.

15. A computer program comprising instructions which, when executed by an apparatus, cause the apparatus to perform at least the following: selection of a set of one or more power amplifiers, from a plurality of power amplifiers, for simultaneous transmission via respective antenna ports, wherein at least some of the plurality of power amplifiers have different maximum output power capabilities.
